# EUROPÄISCHE PATENTSCHRIFT

(11) **EP 1 396 084 B1**
(45) Veröffentlichungstag und Bekanntmachung des Hinweises auf die Patenterteilung: **26.10.2005**
(21) Anmeldenummer: 02769450.4
(22) Anmeldetag: 04.04.2002
(51) Int. Cl.: H03L 7/07

(54) **VERFAHREN ZUR ERZEUGUNG EINES INTERNEN TAKTES IN EINER ELEKTRISCHEN SCHALTUNG UND ENTSPRECHENDE ELEKTRISCHE SCHALTUNG MIT EINEM ZENTRALEN TAKTGENERATOR**
METHOD FOR GENERATING AN INTERNAL CLOCK PULSE IN AN ELECTRIC CIRCUIT AND A CORRESPONDING ELECTRIC CIRCUIT COMPRISING A CENTRAL CLOCK-PULSE GENERATOR
PROCEDE DE PRODUCTION D'UN SIGNAL D'HORLOGE INTERNE DANS UN CIRCUIT ELECTRIQUE ET CIRCUIT ELECTRIQUE CORRESPONDANT POURVU D'UN GENERATEUR D'HORLOGE CENTRAL

(30) Priorität: 11.05.2001 DE 10123932
(43) Veröffentlichungstag der Anmeldung: 10.03.2004
(73) Patentinhaber: SIEMENS AKTIENGESELLSCHAFT, 80333 München (DE)
(72) Erfinder: MARIGGIS, Athanase, 81379 München (DE)
(86) Internationale Anmeldenummer: PCT/DE2002/001343
(87) Internationale Veröffentlichungsnummer: WO 2002/093749

(56) Entgegenhaltungen:
- EP-A- 0 982 889
- US-A- 4 598 257

## Beschreibung

Die Erfindung betrifft ein Verfahren zur Erzeugung eines internen Taktes in einer elektrischen Schaltung und eine entsprechende elektrische Schaltung mit einem zentralen Taktgenerator zur Erzeugung eines internen Taktes. Insbesondere bezieht sich die Erfindung dabei auf ein Telekommunikationssystem mit einem zentralen Taktgenerator zur Erzeugung eines internen Taktes. Telekommunikationssysteme werden für alle nachrichtentechnischen Übertragungsverfahren verwendet, bei denen eine Kommunikation über eine größere Entfernung geschaffen wird. Die Übertragungstechnik umfasst Kabelübertragungstechnik, Sprech- und Datenfunk, Satellitentechnik, Modems, digitale Vermittlungsanlagen und Vermittlungstechnik und lokale Netze. Grundsätzlich lassen sich dabei asynchrone und synchrone Übertragung unterscheiden. Asynchrone Übertragung bedeutet ein zeitlich entkoppelter Austausch von Nachrichten von einem Sender zu einem Empfänger. Demgegenüber wird unter synchroner Übertragung ein Gleichlauf zwischen Sender und Empfänger verstanden. Dabei müssen eine Sende- und die zugehörige Empfangsoperation immer zeitgleich ausgeführt werden. Telekommunikationsnetzwerke sind durch die Möglichkeit des bi- und multidirektionalen Datenaustausches zwischen den Teilnehmern gekennzeichnet. Dies setzt voraus, dass jeder beteiligte Teilnehmer mit jedem anderen über dasselbe Medium kommunizieren kann. Aufgrund verschiedener Standards für Übertragungsnetze sind Kommunikationssysteme erforderlich, die Verbindungen zu mehreren dieser Übertragungsnetze herstellen können. Ein solches Telekommunikationssystem besitzt für jeden unterschiedlichen Übertragungsstandard eine eigene Schnittstelle.

Digitale Systeme, die zusammengeschaltet werden, müssen aufeinander synchronisiert werden, da sonst ein beträchtlicher Datenverlust hingenommen werden muss. Laufen dabei die Taktversorgungen zweier gekoppelter Systeme zu stark auseinander, so muss das System sich gegebenenfalls auf den nächsten Rahmen des Übertragungssystems synchronisieren, wodurch ein Teil eines Rahmens verloren geht. Mobilfunk- und Festnetzkommunikationssysteme beinhalten im Allgemeinen einen zentralen Taktgenerator. Dieser soll auf eine externe Taktquelle mit sehr hoher Genauigkeit synchronisiert werden. Um die Ausfallsicherheit zu erhöhen werden im Allgemeinen mindestens zwei redundante hochgenaue Referenztakte verwendet. Zusätzlich ist der gesamte zentrale Taktgenerator im Allgemeinen gedoppelt. Bezüglich der Synchronisation kann man grundsätzlich eine plesiochrone, eine gegenseitige Synchronisation und eine hierarchische Synchronisation (Master/Slave) unterscheiden.

Bei der hierarchischen Master/Slave-Synchronisation, die auch der vorliegenden Erfindung zugrunde liegt, wird das Netz entsprechend einer Hierarchie synchronisiert, d.h. die jeweils untere Ebene des Netzes synchronisiert sich auf die obere Ebene auf. Ein digitales Vermittlungssystem wird im Allgemeinen durch einen internen Takt synchronisiert, der von einem zentralen Taktgenerator erzeugt wird. Ein solcher zentraler Taktgenerator arbeitet vorteilhafterweise im Master/Slave-Modus. Telekommunikationssysteme, die mit standardisierten Übertragungsnetzen, wie beispielsweise PDH, SDH oder SONET, verbunden sind, erfordern im Allgemeinen eine Synchronisation. Nur so lässt sich die notwendige Taktqualität an der Schnittstelle zum Übertragungsnetz erreichen. Dabei werden zwei Betriebsarten der Synchronisation unterschieden. Im Falle einer externen Synchronisation wird dem System von einer externen Synchronisationsquelle ein Takt direkt zugeführt. Demgegenüber wird bei einer Synchronisation über die Übertragungsstrecke der Takt aus dem empfangenen Datenstrom der Schnittstelle gewonnen und dem System als Synchronisationsquelle zugeführt. Da die Taktqualität einer Taktquelle, zu der das System synchronisiert ist, veränderlich sein und ein Referenztakt auch ausfallen kann, werden zur Synchronisation von Telekommunikationssystemen mindestens zwei zueinander redundante Referenztakte verwendet. Dabei muss der Ausfall bzw. eine Qualitätsabnahme eines Referenztaktes vom Telekommunikationssystem erkannt und sodann automatisch auf den redundanten Referenztakt umgeschaltet werden. Im Allgemeinen wird bei Anwendung des Master-/Slave-Moduses der Master des Synchronisationssystems unter Steuerung durch einen Hauptprozessor mit einem externen Takt synchronisiert, der über eine Schnittstelle von einem der Übertragungssysteme erhalten wird. An einem zweiten Taktgenerator, der im Slave des zentralen Taktgenerators liegt, liegt ebenfalls die externe Taktquelle an. Auf diese Weise wird gewährleistet, dass das gesamte System durch genau eine externe Taktquelle synchronisiert wird. Bei einem Vertausch der Master- und Slave-Funktion der beiden Taktgeneratoren des zentralen Taktgenerators koordiniert im Allgemeinen ein Hauptprozessor die Umschaltung. Nachteilig hierbei ist der große Zeitaufwand. Bei Ausfall oder Abschaltung des Masters kann es deshalb zu Verschiebungen der Taktfrequenz und damit zu Fehlern auf den Übertragungsstrecken kommen, wenn der Slave die Aufgabe des Masters nicht schnell genug übernehmen kann. Um dieses Problem zu vermeiden schlägt die EP 0 982 889 vor, dass der Slave seine Taktsignale synchron zu den Taktsignalen der Referenztaktquelle erzeugt und die erzeugten Taktsignale über eine geeignete elektrische Verbindung dem ersten Taktgenerator zur Verfügung stellt, sobald der Slave über eine weitere geeignete elektrische Verbindung feststellt, dass die von dem Master zur Verfügung gestellten Taktsignale ausgefallen sind. Somit ist kein aufwendiger Nachrichtenverkehr mit einem übergeordneten Prozessor mehr erforderlich. Die EP 0 982 890 schlägt im Zusammenhang mit diesem Problemfeld ferner vor, auf peripheren Plattformen des Telekommunikationssystems Gütedetektoren vorzusehen, die eine Abnahme der Qualität oder den Ausfall eines Taktsignals feststellen und eine Weiterleitung des Taktsignals an den entsprechenden Haupttaktgenerator unterbrechen. Der Haupttaktgenerator stellt mittels eines Unterbrechungsdetektor die Unterbrechung fest und schaltet auf einen redundanten Referenztakt um. Die Verwendung von Gütedetektoren auf peripheren Baugruppen, wodurch die Taktqualität vorgetestet werden soll, ist sehr aufwendig und teuer, weil einerseits auf jeder peripheren Baugruppe, die einen Referenztakt liefern soll, Gütedetektoren benötigt werden und zweitens weil solche Detektoren teuere Quarzoszillatoren für die Qualitätsprüfung des Signals benötigen.

Eine Aufgabe der vorliegenden Erfindung war es, ein Verfahren vorzusehen, mit dessen Hilfe es möglich ist, auf recht einfache und kostengünstige Weise, eine geforderte Qualität eines internen Taktes innerhalb einer elektrischen Schaltung zu gewährleisten. Ferner war es eine Aufgabe der Erfindung eine entsprechende elektrische Schaltung bereitzustellen.

Gelöst werden diese Aufgaben durch ein erfindungsgemäßes Verfahren gemäß Anspruch 1 bzw. durch eine erfindungsgemäße elektrische Schaltung gemäß Anspruch 3. Weitere vorteilhafte Ausführungsformen werden in den entsprechenden Unteransprüchen angeführt.

Gemäß Anspruch 1 wird ein Verfahren zur Erzeugung eines internen Taktes in einer elektrischen Schaltung mit einem ersten Taktgenerator und einem zweiten Taktgenerator bereitgestellt, wobei beide Taktgeneratoren über jeweils mindestens einen Anschluss für eine externe Referenztaktquelle und über jeweils mindestens ein erstes und ein zweites PLL verfügen und wobei die jeweils ersten PLLs der beiden Taktgeneratoren auf Taktsignale von jeweils unterschiedlichen Referenztaktquellen synchronisiert werden und wobei das zweite PLL des zweiten Taktgenerators und das zweite PLL des ersten Taktgenerators auf Basis von von dem ersten PLL des ersten Taktgenerators zur Verfügung gestellten Taktsignale Taktsignale erzeugen, wenn das erste PLL des ersten Taktgenerators Taktsignale zur Verfügung stellt und das zweite PLL des zweiten Taktgenerators und das zweite PLL des ersten Taktgenerators Taktsignale auf Basis von von dem ersten PLL des zweiten Taktgenerators zur Verfügung gestellten Taktsignale erzeugen, sobald der zweite Taktgenerator feststellt, dass von dem ersten PLL des ersten Taktgenerators keine Taktsignale zur Verfügung gestellt werden.

Grundsätzlich beinhaltet jeder Taktgenerator mindestens zwei PLLs (Phase Locked Loop). Ein erstes PLL umfasst einen hochgenauen, aber niederfrequenten Oszillator. Dieser wird benötigt, um die Qualität des geforderten Taktes zu erreichen. Im Allgemeinen sind derartige hochgenauen Oszillatoren sehr teuer. Das zweite PLL erzeugt üblicherweise den benötigten hochfrequenten Takt und sorgt für eine durch entsprechende Standards vorgeschriebene Phasenbeziehung zwischen den beiden Taktgeneratoren bzw. zwischen Master und Slave. Das zweite PLL hat somit eine Art Multiplikatorfunktion in Bezug auf das durch das erste PLL erzeugte Taktsignal.

In bekannten Systemen, wie beispielsweise EWSD oder EWSP, werden beide Teile des redundanten Taktgenerators auf dem selben Referenztakt synchronisiert oder indirekt der Slave auf den Master, wie beispielsweise beim MainstreetXpress 36190.

Gemäß der vorliegenden Erfindung werden nun hingegen das erste PLL des ersten Taktgenerators, vorzugsweise eines Master Taktgenerators, und das erste PLL des zweiten Taktgenerators, vorzugsweise eines Slave Taktgenerators, auf unterschiedliche Referenztakte synchronisiert. In einer bevorzugten Ausführungsform des Verfahrens erfolgt dies gleichzeitig. Somit wird gleichzeitig die Qualität von beiden externen Referenztakten kontrolliert. Ferner ist es auch möglich mehrere Referenztakte einzuspeisen und beispielsweise mit einer zyklischen Steuerung deren Qualität durch den ersten PLL des Slave Taktgenerators zu testen bzw. zu kontrollieren.

Das zweite PLL des zweiten Taktgenerators bzw. des Slave Taktgenerators erzeugt jedoch Taktsignale basierend auf den durch das erste PLL des ersten Taktgenerators bzw. des Master Taktgenerators zur Verfügung gestellten Taktsignale. Somit erhält man im Normalbetrieb zwei identische redundante Taktsignale.

Ein Ausfall des Taktsignals von dem ersten PLL des ersten Taktgenerators wird von dem zweiten Taktgenerator erkannt und als Auslöser angesehen, eine Umschaltung vorzunehmen und zwar derart, dass das zweite PLL des zweiten Taktgenerators nunmehr Taktsignale erzeugt, die auf von dem ersten PLL des zweiten Taktgenerators zur Verfügung gestellten Taktsignalen basieren. Ebenso findet im ersten Taktgenerator eine Umschaltung statt, so dass das zweite PLL des ersten Taktgenerators ebenfalls Taktsignale erzeugt, die auf von dem ersten PLL des zweiten Taktgenerators zur Verfügung gestellten Taktsignalen basieren. Ein großer Vorteil der vorliegenden Erfindung ist darin zu sehen, dass mit dem Umschalten keinerlei Zeitverlust einhergeht, da die ersten PLLs der beiden Taktgeneratoren gleichzeitig zwei unterschiedliche externe Referenztakte hinsichtlich ihrer Qualität bzw. Güte prüfen. Die Synchronisation der ersten hochgenauen PLLs dauert im Allgemeinen mehrere Stunden, während die anschließende Synchronisation der zweiten PLLs relativ schnell vonstatten geht. Wird nun ein Umschalten erforderlich, da beispielsweise ein erster Referenztakt, auf welchen das erste PLL des ersten Taktgenerators synchronisiert werden soll, nicht die entsprechende Qualität aufweist, so stellt erfindungsgemäß der erste PLL des zweiten Taktgenerators ohne Zeitverzögerung Taktsignale zur Verfügung, die auf einen zweiten Referenztakt bereits synchronisiert sind. In bisherigen Systemen musste zum Zeitpunkt eines nötigen Umschaltens bei eventuell mangelnder Güte eines ersten Referenztaktes zunächst erst ein zweiter Referenztakt hinsichtlich seiner Güte geprüft werden, was, wie bereits erwähnt, viel Zeit in Anspruch nimmt. Dadurch kann es zu Verschiebungen der Taktfrequenz und damit zu Fehlern kommen, was durch das erfindungsgemäße Verfahren verhindert werden kann, da hier zwei unterschiedliche Referenztakte zeitgleich und nicht nacheinander hinsichtlich ihrer Qualität geprüft werden.

Ferner war es eine Aufgabe der vorliegenden Erfindung, eine elektrische Schaltung zur Verfügung zustellen, mit deren Hilfe ein interner Takt einer geforderten Qualität zur Verfügung gestellt werden kann.

Diese Aufgabe wird erfindungsgemäß gelöst durch eine elektrische Schaltung mit einem zentralen Taktgenerator zur Erzeugung eines internen Taktes, wobei der zentrale Taktgenerator mindestens die folgenden Elemente aufweist:
einen ersten Taktgenerator und einen zweiten Taktgenerator mit jeweils mindestens einem Anschluss für eine externe Referenzquelle und jeweils mindestens einem ersten und einem zweiten PLL,
mindestens eine erste schaltbare Verbindung zwischen dem ersten und dem zweiten Taktgenerator zur Weiterleitung eines Taktsignals von dem ersten Taktgenerator zu dem zweiten Taktgenerator ,
mindestens eine zweite schaltbare Verbindung zwischen dem ersten und dem zweiten Taktgenerator zur Weiterleitung eines Taktsignals von dem zweiten Taktgenerator zu dem ersten Taktgenerator und wobei die jeweils ersten PLLs der beiden Taktgeneratoren auf Taktsignale von jeweils unterschiedlichen Referenztaktquellen synchronisiert sind und das zweite PLL des zweiten Taktgenerators über die mindestens eine erste schaltbare Verbindung zwischen dem ersten und dem zweiten Taktgenerator auf Basis von von dem ersten PLL des ersten Taktgenerators zur Verfügung gestellten Taktsignale Taktsignale erzeugen kann und das zweite PLL des ersten Taktgenerators über die mindestens eine zweite schaltbare Verbindung zwischen dem ersten und dem zweiten Taktgenerator auf Basis von von dem ersten PLL des zweiten Taktgenerators zur Verfügung gestellten Taktsignale Taktsignale erzeugen kann, wobei die jeweiligen zweiten PLLs stets auf Basis der gleichen Taktsignale Taktsignale erzeugen.

Das bedeutet, dass das zweite PLL des ersten Taktgenerators nur Taktsignale basierend auf von dem ersten PLL des zweiten Taktgenerators zur Verfügung gestellten Taktsignale erzeugt, wenn das zweite PLL des zweiten Taktgenerators ebenfalls Taktsignale basierend auf von dem ersten PLL des zweiten Taktgenerators zur Verfügung gestellten Taktsignale erzeugt. Das Gleiche gilt, wenn das zweite PLL des ersten Taktgenerators Taktsignale erzeugt, die auf Taktsignalen beruhen, die von dem ersten PLL des ersten Taktgenerators zur Verfügung gestellt werden. Dann nämlich erzeugt auch das zweite PLL des zweiten Taktgenerators Taktsignale basierend auf Taktsignalen, die von dem ersten PLL des ersten Taktgenerators zur Verfügung gestellt werden.

In einer bevorzugten Ausführungsform der erfindungsgemäßen elektrischen Schaltung weist der zweite Taktgenerator mindestens die folgenden weiteren Elemente auf:
- einen Detektoreinrichtung zum Detektieren eines Ausbleibens des von dem ersten PLL des ersten Taktgenerators zur Verfügung gestellten Taktsignals,
- eine Umschaltvorrichtung zur Auswahl eines Taktsignals, basierend auf dem der zweite PLL des zweiten Taktgenerators sein Taktsignal erzeugt, wobei die Umschaltvorrichtung das vom ersten PLL des ersten Taktgenerators zur Verfügung gestellte Taktsignal als Basis auswählt, solange die Detektoreinrichtung kein Ausbleiben detektiert, und wobei die Umschaltvorrichtung das von dem ersten PLL des zweiten Taktgenerators zur Verfügung gestellte Taktsignal als Basis auswählt, wenn die Detektoreinrichtung ein Ausbleiben detektiert und dass
der erste Taktgenerator mindestens die folgenden weiteren Elemente aufweist:
- einen Detektoreinrichtung zum Detektieren eines vom ersten PLL des zweiten Taktgenerators zur Verfügung gestellten Taktsignals, eine Umschaltvorrichtung zur Auswahl eines Taktsignals, basierend auf dem der zweite PLL des ersten Taktgenerators sein Taktsignal erzeugt, wobei die Umschaltvorrichtung das vom ersten PLL des ersten Taktgenerators zur Verfügung gestellte Taktsignal als Basis auswählt, solange die Detektoreinrichtung des zweiten Taktgenerators kein Ausbleiben detektiert, und wobei die Umschaltvorrichtung das von dem ersten PLL des zweiten Taktgenerators zur Verfügung gestellte Taktsignal als Basis auswählt, wenn die Detektoreinrichtung ein Ausbleiben detektiert.

Vorzugsweise stellt die elektrische Schaltung ein Telekommunikationssystem dar, das mit mindestens einem einer Mehrzahl verschiedener Übertragungsnetze verbindbar ist und über dieses mindestens eine Übertragungsnetz Daten übertragen kann. Vorzugsweise ist das Telekommunikationssystem mit einer Mehrzahl von Übertragungsnetzen verbindbar. Besonders bevorzugt umfasst diese Mehrzahl der Übertragungsnetze ein Übertragungsnetz gemäß dem SDH-Übertragungsstandard.

Weiterhin bevorzugt umfasst die Mehrzahl der Übertragungsnetze ein Übertragungsnetz gemäß dem PDH-Übertragungsstandard und/oder ein Übertragungsnetz gemäß dem SONET-Übertragungsstandard.

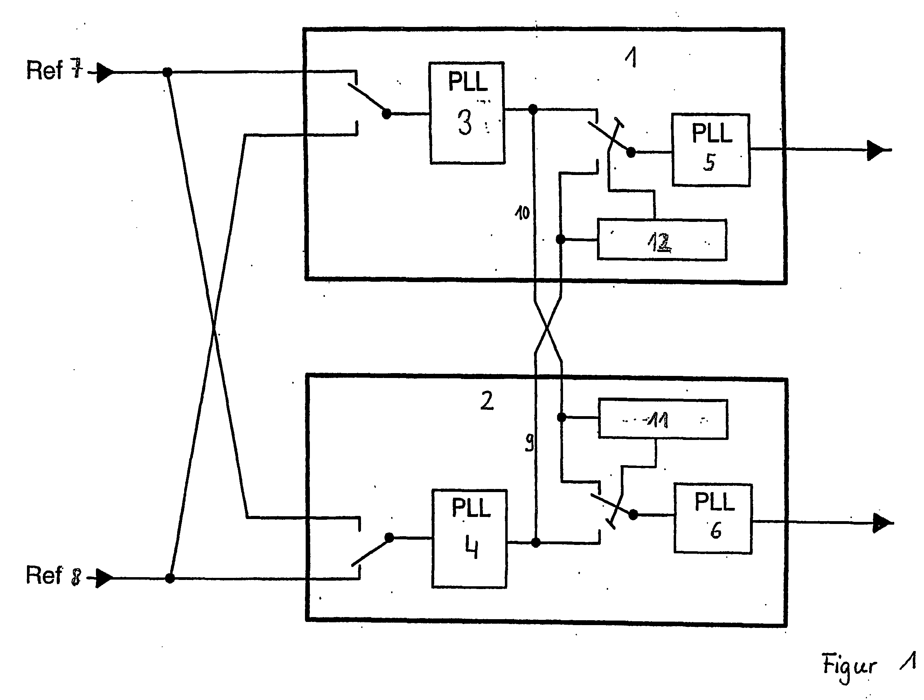

Weitere Vorteile der vorliegenden Erfindung werden anhand der folgenden Figur erläutert. Es zeigt
Fig.1 Schematische Darstellung einer Ausführungsform eines zentralen Taktgenerators einer erfindungsgemäßen Schaltung

In Figur 1 ist eine der Erfindung zugrunde liegende Konstellation eines zentralen Taktgenerators einer erfindungsgemäßen elektrischen Schaltung gezeigt. Ein erster Taktgenerator 1 und ein zweiter Taktgenerator 2 verfügen jeweils über ein erstes PLL 3, 4 und ein zweites PLL 5, 6. Das erste PLL 3 des ersten Taktgenerators 1 wird von einem externen Takt 7 versorgt, während das erste PLL 4 des zweiten Taktgenerators 2 von einem externen Takt 8 versorgt wird. Dies kann durch entsprechende Umschaltvorrichtungen auch vertauscht werden, so dass das PLL 3 von dem externen Takt 8 und das PLL 4 von dem externen Takt 7 versorgt wird. Zusätzlich sind schaltbare elektrische Verbindungen 9, 10 zwischen den beiden Taktgeneratoren 1 und 2 vorgesehen zur Weiterleitung von Taktsignalen. Normalerweise werden beide Taktgeneratoren im Master/Slave-Betrieb betrieben. Das erste PLL 3 des ersten Taktgenerators 1 erzeugt Taktsignale basierend auf dem externen Takt 7. Gleichzeitig stellt das erste PLL 4 des zweiten Taktgenerators 2 Taktsignale bereit, die auf der Basis des externen Taktes 8 erzeugt werden. Das zweite PLL 5 des ersten Taktgenerators 1 erzeugt sodann Taktsignale basierend auf den Taktsignalen, die vom ersten PLL 3 des ersten Taktgenerators 1 bereitgestellt werden. Das zweite PLL 6 des zweiten Taktgenerators 2 erzeugt ebenfalls Taktsignale auf den Taktsignalen des ersten PLL 3 des ersten Taktgenerators 1, die ihm über die Verbindung 10 zur Verfügung gestellt werden. Beim Auftreten eines Fehlers auf der Verbindung 10 kann dies mit Hilfe einer Detektoreinrichtung 11 erfasst werden. Daraufhin erfolgt eine Umschaltung derart, dass das zweite PLL 6 des zweiten Taktgenerators 2 Taktsignale erzeugt, die auf den Taktsignalen basieren, die von dem ersten PLL 4 des zweiten Taktgenerators 2 zur Verfügung gestellt werden. Gleichzeitig erzeugt auch das zweite PLL 5 des ersten Taktgenerators 1 Taktsignale basierend auf den von dem ersten PLL 4 des zweiten Taktgenerators 2 ihm über die Verbindung 9 zur Verfügung gestellten Taktsignalen. Eine Detektoreinrichtung 12 in der Verbindung 9 erkennt, wenn auf der Verbindung 9 ein Taktsignal bereitgestellt wird. Dadurch erkennt das zweite PLL 5 des ersten Taktgenerators 1, dass das erste PLL 3 des ersten Taktgenerators 1 nicht in der Lage ist, ein Taktsignal geforderter Qualität zur Verfügung zu stellen und wird, wie bereits erläutert, entsprechend umgeschaltet.

## Patentansprüche

1. Verfahren zur Erzeugung eines internen Taktes in einer elektrischen Schaltung mit
einem ersten Taktgenerator (1) und einem zweiten Taktgenerator (2), wobei beide Taktgeneratoren (1, 2) über jeweils mindestens einen Anschluss für eine externe Referenztaktquelle (7, 8) und über jeweils mindestens ein erstes (3, 4) und ein zweites (5, 6) PLL verfügen,
**dadurch gekennzeichnet, dass**
die jeweils ersten PLLs (3, 4) der beiden Taktgeneratoren (1, 2) auf Taktsignale von jeweils unterschiedlichen Referenztaktquellen (7, 8) synchronisiert werden und
dass das zweite PLL (6) des zweiten Taktgenerators (2) und das zweite PLL (5) des ersten Taktgenerators (1) auf Basis von von dem ersten PLL (3) des ersten Taktgenerators (1) zur Verfügung gestellten Taktsignale interne Taktsignale erzeugen, wenn das erste PLL (3) des ersten Taktgenerators (1) Taktsignale zur Verfügung stellt und
dass der zweite PLL (6) des zweiten Taktgenerators (2) und der zweite PLL (5) des ersten Taktgenerators (1) auf Basis von von dem ersten PLL (4) des zweiten Taktgenerators (2) zur Verfügung gestellten Taktsignale interne Taktsignale erzeugen, sobald der zweite Taktgenerator (2) feststellt, dass von dem ersten PLL (3) des ersten Taktgenerators (1) keine Taktsignale zur Verfügung gestellt werden.

2. Verfahren nach Anspruch 1,
**dadurch gekennzeichnet, dass**
die jeweils ersten PLLs der beiden Taktgeneratoren gleichzeitig auf Taktsignale von jeweils unterschiedlichen Referenztaktquellen synchronisiert werden.

3. Elektrische Schaltung mit einem zentralen Taktgenerator zur Erzeugung eines internen Taktes, wobei der zentrale Taktgenerator mindestens die folgenden Elemente aufweist: einen ersten Taktgenerator (1) und einen zweiten Taktgenerator (2) mit jeweils mindestens einem Anschluss für eine externe Referenzquelle (7, 8) und jeweils mindestens einem ersten (3, 4) und einem zweiten (5, 6) PLL,
mindestens eine erste schaltbare Verbindung (10) zwischen dem ersten (1) und dem zweiten (2) Taktgenerator zur Weiterleitung eines Taktsignals von dem ersten Taktgenerator (1) zu dem zweiten Taktgenerator (2),
mindestens eine zweite schaltbare Verbindung (9) zwischen dem ersten (1) und dem zweiten Taktgenerator (2) zur Weiterleitung eines Taktsignals von dem zweiten Taktgenerator zu dem ersten Taktgenerator (1)
**dadurch gekennzeichnet, dass**
die jeweils ersten PLLs (3, 4) der beiden Taktgeneratoren (1, 2) auf Taktsignale von jeweils unterschiedlichen Referenztaktquellen (7, 8) synchronisiert sind und
dass das zweite PLL (6) des zweiten Taktgenerators (2) über die mindestens eine erste schaltbare Verbindung (10) zwischen dem ersten (1) und dem zweiten (2) Taktgenerator auf Basis von von dem ersten PLL (3) des ersten Taktgenerators (1) zur Verfügung gestellten Taktsignale interne Taktsignale erzeugen kann, wenn das erste PLL (3) des ersten Taktgenerators (1) Taktsignale zur Verfügung stellt und das zweite PLL (5) des ersten Taktgenerators (1) über die mindestens eine zweite schaltbare Verbindung (9) zwischen dem ersten (1) und dem zweiten (2) Taktgenerator auf Basis von von dem ersten PLL (4) des zweiten Taktgenerators (2) zur Verfügung gestellten Taktsignale interne Taktsignale erzeugen kann, sobald der zweite Taktgenerator (2) feststellt, dass von dem ersten PLL (3) des ersten Taktgenerators (1) keine Taktsignale zur Verfügung gestellt werden, wobei die jeweiligen zweiten PLLs (5, 6) stets auf Basis der gleichen Taktsignale Taktsignale erzeugen.

4. Elektrische Schaltung nach Anspruch 3,
**dadurch gekennzeichnet, dass**
der zweite Taktgenerator mindestens die folgenden weiteren Elemente aufweist:
- einen Detektoreinrichtung (11) zum Detektieren eines Ausbleibens des vom ersten PLL (3) des ersten Taktgenerators (1) zur Verfügung gestellten Taktsignals,
- eine Umschaltvorrichtung zur Auswahl eines Taktsignals, basierend auf dem der zweite PLL (6) des zweiten Taktgenerators (2) sein Taktsignal erzeugt, wobei die Umschaltvorrichtung das vom ersten PLL (3) des ersten Taktgenerators (1) zur Verfügung gestellte Taktsignal als Basis auswählt, solange die Detektoreinrichtung (11) kein Ausbleiben detektiert, und wobei die Umschaltvorrichtung das von dem ersten PLL (4) des zweiten Taktgenerators (2) zur Verfügung gestellte Taktsignal als Basis auswählt, wenn die Detektoreinrichtung (11) ein Ausbleiben detektiert und dass
der erste Taktgenerator (1) mindestens die folgenden weiteren Elemente aufweist:
- einen Detektoreinrichtung (12) zum Detektieren eines vom ersten PLL (4) des zweiten Taktgenerators (2) zur Verfügung gestellten Taktsignals,
- eine Umschaltvorrichtung zur Auswahl eines Taktsignals, basierend auf dem der zweite PLL (5) des ersten Taktgenerators (1) sein Taktsignal erzeugt, wobei die Umschaltvorrichtung das vom ersten PLL (3) des ersten Taktgenerators (1) zur Verfügung gestellte Taktsignal als Basis auswählt, solange die Detektoreinrichtung (11) des zweiten Taktgenerators (2) kein Ausbleiben detektiert, und wobei die Umschaltvorrichtung das von dem ersten PLL (4) des zweiten Taktgenerators (2) zur Verfügung gestellte Taktsignal als Basis auswählt, wenn die Detektoreinrichtung (11) ein Ausbleiben detektiert.

5. Elektrische Schaltung nach einem der Ansprüche 3 oder 4,
**dadurch gekennzeichnet, dass**
die elektrische Schaltung ein Telekommunikationssystem darstellt, das mit mindestens einem einer Mehrzahl verschiedener Übertragungsnetze verbindbar ist, insbesondere mit der gesamten Mehrheit, und Daten darüber übertragen kann.

6. Elektrische Schaltung nach Anspruch 5,
**dadurch gekennzeichnet, dass**
die Mehrzahl der Übertragungsnetze ein Übertragungsnetz gemäß dem SDH-Übertragungsstandard umfasst.

7. Elektrische Schaltung nach Anspruch 5 oder 6,
**dadurch gekennzeichnet, dass**
die Mehrzahl der Übertragungsnetze ein Übertragungsnetz gemäß dem PDH-Übertragungsstandard umfasst.

8. Elektrische Schaltung nach einem der Ansprüche 5 bis 7,
**dadurch gekennzeichnet, dass**
die Mehrzahl der Übertragungsnetze ein Übertragungsnetz gemäß dem SONET-Übertragungsstandard umfasst.

## Claims

1. Method for production of an internal clock in an electrical circuit having
a first clock generator (1) and a second clock generator (2), with both clock generators (1, 2) each having at least one connection for an external reference clock source (7, 8) and each having at least one first PLL (3, 4) and one second PLL (5, 6),
**characterized in that**
the respective first PLLs (3, 4) of the two clock generators (1, 2) are synchronized to clock signals from respectively different reference clock sources (7, 8),
and **in that** the second PLL (6) for the second clock generator (2) and the second PLL (5) for the first clock generator (1) produce internal clock signals on the basis of clock signals which are produced by the first PLL (3) for the first clock generator (1), when the first PLL (3) for the first clock generator (1) produces clock signals, and
**in that** the second PLL (6) for the second clock generator (2) and the second PLL (5) for the first clock generator (1) produce internal clock signals on the basis of clock signals which are produced by the first PLL (4) for the second clock generator (2) as soon as the second clock generator (2) determines that no clock signals are being produced by the first PLL (3) for the first clock generator (1).

2. Method according to Claim 1,
**characterized in that** each of the first PLLs of the two clock generators are at the same time synchronized in clock signals from respectively different reference clock sources.

3. Electrical circuit having a central clock generator for production of an internal clock, with the central clock generator having at least the following elements:
a first clock generator (1) and a second clock generator (2) each having at least one connection for an external reference source (7, 8) and each having at least one first PLL (3, 4) and one second PLL (5, 6),
at least one first switchable connection (10) between the first clock generator (1) and the second clock generator (2), in order to pass on a clock signal from the first clock generator (1) to the second clock generator (2),
at least one second switchable connection (9) between the first clock generator (1) and the second clock generator (2), for passing on a clock signal from the second clock generator to the first clock generator (1),
**characterized in that**
the respective first PLLs (3, 4) of the two clock generators (1, 2) are synchronized in clock signals from respectively different reference clock sources (7, 8), and
**in that** the second PLL (6) for the second clock generator (2) can produce internal clock signals via the at least one first switchable connection (10) between the first clock generator (1) and the second clock generator (2), on the basis of clock signals which are produced by the first PLL (3) for the first clock generator (1), when the first PLL (3) for the first clock generator (1) produces clock signals, and the second PLL (5) for the first clock generator (1) can produce internal clock signals via the at least one second switchable connection (9) between the first clock generator (1) and the second clock generator (2) on the basis of clock signals which are produced by the first PLL (4) for the second clock generator (2) as soon as the second clock generator (2) determines that no clock signals are being produced by the first PLL (3) for the first clock generator (1), with the respective second PLLs (5, 6) always producing clock signals on the basis of the same clock signals.

4. Electrical circuit according to Claim 3
**characterized in that**
the second clock generator has at least the following further elements:
- a detector device (11) for detection of the absence of the clock signal which is produced by the first PLL (3) for the first clock generator (1),
- a switching apparatus for selection of a clock signal, on the basis of which the second PLL (6) for the second clock generator (2) produces its clock signal, with the switching apparatus selecting as the basis the clock signal which is produced by the first PLL (3) for the first clock generator (1), as long as the detector device (11) detects no absence, and with the switching apparatus selecting as the basis the clock signal which is produced by the first PLL (4) for the second clock generator (2) when the detector device (11) detects absence, and **in that**
the first clock generator (1) has at least the following further elements:
- a detector device (12) for detection of a clock signal which is produced by the first PLL (4) for the second clock generator (2),
- a switching apparatus for selection of a clock signal, on the basis of which the second PLL (5) for the first clock generator (1) produces its clock signal, with the switching apparatus selecting as the basis the clock signal which is produced by the first PLL (3) for the first clock generator (1) for as long as the detector device (11) for the second clock generator (2) detects no absence, and with the switching apparatus selecting as the basis the clock signal which is produced by the first PLL (4) for the second clock generator (2) when the detector device (11) detects absence.

5. Electrical circuit according to one of Claims 3 or 4,
**characterized in that**
the electrical circuit represents a telecommunications system which can be connected to at least one of two or more different transmission networks, in particular to the overall majority, and can transmit data via it or them.

6. Electrical circuit according to Claim 5,
**characterized in that**
the two or more transmission networks comprise a transmission network in accordance with the SDH transmission standard.

7. Electrical circuit according to Claim 5 or 6,
**characterized in that**
the two or more transmission networks comprise a transmission network according to the PDH transmission standard.

8. Electrical circuit according to Claims 5 to 7,
**characterized in that**
the two or more transmission networks comprise a transmission network according to the SONET transmission standard.

## Revendications

1. Procédé pour la production d'une horloge interne dans un circuit électrique,
avec un premier générateur d'horloge (1) et avec un deuxième générateur d'horloge (2), les deux générateurs d'horloge (1, 2) disposant chacun au moins d'une connexion pour une source d'horloge de référence externe (7, 8) et au moins d'un premier PLL (3, 4) et d'un deuxième PLL (5, 6),
**caractérisé**
**en ce que** les premiers PLL respectifs (3, 4) des deux générateurs d'horloge (1, 2) sont synchronisés sur des signaux d'horloge de sources d'horloge de référence respectivement différentes (7, 8)
et **en ce que** le deuxième PLL (6) du deuxième générateur d'horloge (2) et le deuxième PLL (5) du premier générateur d'horloge (1) produisent des signaux d'horloge internes sur la base de signaux d'horloge fournis par le premier PLL (3) du premier générateur d'horloge (1) lorsque le premier PLL (3) du premier générateur d'horloge (1) fournit des signaux d'horloge
et **en ce que** le deuxième PLL (6) du deuxième générateur d'horloge (2) et le deuxième PLL (5) du premier générateur d'horloge (1) produisent des signaux d'horloge internes sur la base de signaux d'horloge fournis par le premier PLL (4) du deuxième générateur d'horloge (2) dès que le deuxième générateur d'horloge (2) constate que le premier PLL (3) du premier générateur d'horloge (1) ne fournit plus de signaux d'horloge.

2. Procédé selon la revendication 1,
**caractérisé en ce que**
les premiers PLL respectifs des deux générateurs d'horloge sont synchronisés simultanément sur des signaux d'horloge de sources d'horloge de référence respectivement différentes.

3. Circuit électrique avec un générateur d'horloge central pour la production d'une horloge interne, le générateur d'horloge central comportant au moins les éléments suivants :
un premier générateur d'horloge (1) et un deuxième générateur d'horloge (2) avec chacun au moins une connexion pour une source de référence externe (7, 8) et
chacun au moins un premier PLL (3, 4) et un deuxième PLL (5, 6),
au moins une première liaison commutable (10) entre le premier générateur d'horloge (1) et le deuxième générateur d'horloge (2) pour la retransmission d'un signal d'horloge du premier générateur d'horloge (1) au deuxième générateur d'horloge (2),
au moins une deuxième liaison commutable (9) entre le premier générateur d'horloge (1) et le deuxième générateur d'horloge (2) pour la retransmission d'un signal d'horloge du deuxième générateur d'horloge au premier générateur d'horloge (1),
**caractérisé**
**en ce que** les premiers PLL respectifs (3, 4) des deux générateurs d'horloge (1, 2) sont synchronisés sur des signaux d'horloge de sources d'horloge de référence respectivement différentes (7, 8)
et **en ce que** le deuxième PLL (6) du deuxième générateur d'horloge (2) peut produire des signaux d'horloge internes, par l'intermédiaire de la ou des premières liaisons commutables (10) entre le premier générateur d'horloge (1) et le deuxième générateur d'horloge (2), sur la base de signaux d'horloge fournis par le premier PLL (3) du premier générateur d'horloge (1) lorsque le premier PLL (3) du premier générateur d'horloge (1) fournit des signaux d'horloge
et **en ce que** le deuxième PLL (5) du premier générateur d'horloge (1) peut produire des signaux d'horloge internes, par l'intermédiaire du ou des deuxièmes liaisons commutables (9) entre le premier générateur d'horloge (1) et le deuxième générateur d'horloge (2), sur la base de signaux d'horloge fournis par le premier PLL (4) du deuxième générateur d'horloge (2) dès que le deuxième générateur d'horloge (2) constate que le premier PLL (3) du premier générateur d'horloge (1) ne fournit pas de signaux d'horloge, les deuxièmes PLL respectifs (5, 6) produisant toujours des signaux d'horloge sur la base des même signaux d'horloge.

4. Circuit électrique selon la revendication 3, **caractérisé en ce que** le deuxième générateur d'horloge comporte au moins les autres éléments suivants :
- un dispositif détecteur (11) pour détecter une absence du signal d'horloge fourni par le premier PLL (3) du premier générateur d'horloge (1),
- un dispositif de commutation pour la sélection d'un signal d'horloge sur la base duquel le deuxième PLL (6) du deuxième générateur d'horloge (2) produit son signal d'horloge, le dispositif de commutation sélectionnant comme base le signal d'horloge fourni par le premier PLL (3) du premier générateur d'horloge (1) tant que le dispositif détecteur (11) ne détecte pas d'absence de signal et le dispositif de commutation sélectionnant comme base le signal d'horloge fourni par le premier PLL (4) du deuxième générateur d'horloge (2) lorsque le dispositif détecteur (11) détecte une absence de signal,
et **en ce que** le premier générateur d'horloge (1) comporte au moins les autres éléments suivants :
- un dispositif détecteur (12) pour détecter un signal d'horloge fourni par le premier PLL (4) du deuxième générateur d'horloge (2),
- un dispositif de commutation pour la sélection d'un signal d'horloge sur la base duquel le deuxième PLL (5) du premier générateur d'horloge (1) produit son signal d'horloge, le dispositif de commutation sélectionnant comme base le signal d'horloge fourni par le premier PLL (3) du premier générateur d'horloge (1) tant que le dispositif détecteur (11) du deuxième générateur d'horloge (2) ne détecte pas d'absence de signal et le dispositif de commutation sélectionnant comme base le signal d'horloge fourni par le premier PLL (4) du deuxième générateur d'horloge (2) lorsque le dispositif détecteur (11) détecte une absence de signal.

5. Circuit électrique selon l'une des revendications 3 ou 4,
**caractérisé en ce que**
le circuit électrique représente un système de télécommunication qui peut être relié à au moins l'un des différents réseaux de transmission, notamment avec la totalité de ceux-ci, et peut transmettre des données par l'intermédiaire de ceux-ci.

6. Circuit électrique selon la revendication 5,
**caractérisé en ce que**
la multiplicité des réseaux de transmission comprend un réseau de transmission selon le standard de transmission SDH.

7. Circuit électrique selon la revendication 5 ou 6,
**caractérisé en ce que**
la multiplicité des réseaux de transmission comprend un réseau de transmission selon le standard de transmission PDH.

8. Circuit électrique selon l'une des revendications 5 à 7,
**caractérisé en ce que**
la multiplicité des réseaux de transmission comprend un réseau de transmission selon le standard de transmission SONET.
